# EUROPÄISCHE PATENTSCHRIFT

(11) **EP 0 561 289 B1**
(45) Veröffentlichungstag und Bekanntmachung des Hinweises auf die Patenterteilung: **30.10.1996**
(21) Anmeldenummer: 93103998.6
(22) Anmeldetag: 12.03.1993
(51) Int. Cl.: G02B 1/00, G02B 1/10, G02B 5/28

(54) **Aufdampfmaterial zur Herstellung hochbrechender optischer Schichten**
Material for vapour deposition for the production of high refractive optical layers
Matériau pour la deposition par vapeur pour la fabrication des couches optiques à haute index de refraction

(30) Priorität: 19.03.1992 DE 4208811
(43) Veröffentlichungstag der Anmeldung: 22.09.1993
(73) Patentinhaber: MERCK PATENT GmbH, D-64271 Darmstadt (DE)
(72) Erfinder: Friz, Martin, Dr., W-6109 Mühltal 4 (DE); Albrecht, Detlef, W-6103 Griesheim (DE)

(56) Entgegenhaltungen:
- DE-A- 1 228 489
- JP-A- 1 036 764
- US-A- 4 144 076
- US-A- 5 108 846
- PATENT ABSTRACTS OF JAPAN vol. 6, no. 27, 17. Februar 1982; & JP-A-56 147 101

## Beschreibung

Dünne Oxidschichten werden in der Technik, insbesondere in der Optik, in großem Umfang als Schutzschichten oder für optische Funktionszwecke verwendet. So können sie als Schutz gegen Korrosion und mechanische Beschädigung oder zur Vergütung der Oberflächen optischer Bauteile und Instrumente, wie insbesondere Linsen, Spiegel, Prismen etc. dienen. Weiterhin werden dünne Oxidschichten zur Herstellung hoch-, mittel- und niedrigbrechender optischer Schichten zur Reflexionserhöhung oder -erniedrigung gebraucht. Hauptanwendungsgebiete sind die Herstellung von Antireflex- und Vergütungsschichten auf Brillengläsern sowie auf Linsen für Kameraobjektive, Ferngläser und optische Bauteile für optische Meßinstrumente und für die Lasertechnik. Weiterhin sind dies die Herstellung von Schichten mit bestimmtem Brechungsindex und/oder bestimmten optischen Absorptionseigenschaften, beispielsweise bei Interferrenzspiegeln, Strahlenteilern, Wärmefiltern und Kaltlichtspiegeln.

Ausgangsmaterialien zur Herstellung derartiger Oxidschichten sind an sich bekannt. Üblich sind SiO₂ sowie eine Vielfalt von Metalloxiden, ggf. in Kombination miteinander. Die Auswahl erfolgt im wesentlichen empirisch nach Maßgabe der angestrebten optischen Eigenschaften und der Verarbeitbarkeit. Die Herstellung der Schichten erfolgt nach der an sich bekannten Vakuum-Aufdampftechnik. Zur beispielhaften Illustration sei hier die DE-PS 12 28 489 zitiert, aus der sich Hinweise zu verwendbaren Materialien und zur Verarbeitungstechnik sowie zu den in dem Zusammenhang stehenden Problematiken entnehmen lassen.

Für die Herstellung von hochbrechenden Schichten, also Schichten, die einen optischen Brechungsindex um den Wert 2 aufweisen, ist die Auswahl an prinzipiell geeigneten Ausgangsstoffen begrenzt. Als Ausgangsmaterialien kommen im wesentlichen die Oxide von Titan, Zirkon, Hafnium und Tantal sowie Mischsysteme hiervon in Frage. Bevorzugtes Ausgangsmaterial für hochbrechende Schichten ist Titandioxid.

Diese an sich geeigneten Materialien haben jedoch eine Reihe von Nachteilen, die sich insbesondere in verarbeitungspraktischer Hinsicht bemerkbar machen.

Ein Gesichtspunkt hierbei ist, daß diese Substanzen hohe Schmelz- und Siedepunkte haben, die außerdem relativ nähe beieinander liegen. Aus praktischer Hinsicht ist es aber wichtig, daß die Aufdampfmaterialien vor dem Beginn einer merklichen Abdampfung vollständig eingeschmolzen sind. Nur dann ist eine gleichmäßige und ausreichende Abdampfrate gewährleistet. Diese ist erforderlich, damit sich auf den zu bedampfenden Objekten homogene und gleichmäßig dicke Schichten ausbilden. Bei den Oxiden von Zirkon und Hafnium sowie bei Titan-Zirkon-Mischoxidsystemen ist dies aber unter praktischen Anwendungsbedingungen nicht der Fall. Die genannten Substanzen schmelzen unter den üblichen Arbeitsbedingungen nicht bzw. nicht vollständig ein. Sie sind insgesamt schwierig zu verdampfen und man erhält Schichten mit Schichtdicken-Schwankungen.

Man ist daher bestrebt, durch geeignete Zusätze die Schmelzpunkte der Grundmaterialien herabzusetzen. Zusätze dienen weiterhin dazu, den Brechungsindex in der erhaltenen Schicht in bestimmten Grenzen zu variieren und gezielt einzustellen.

Die Auswahl an geeigneten Zusätzen für diese Zwecke ist durch die Forderung nach Absorptionsfreiheit eingeschränkt. Es kommen daher nur solche Metalloxide als entsprechende Zusätze in Frage, die im sichtbaren Spektralbereich bis in den nahen UV-Wellenlängenbereich (ca. bis 320 nm) keine Absorptionen haben.

Ein weiteres Problem ist das folgende:

Als Ausgangsmaterial haben die genannten Oxide zwar an sich keine oder nur geringe Absorptionen im sichtbaren Wellenlängenbereich, was Grundvoraussetzung für entsprechende optische Anwendungen ist. Ohne spezielle Vorsichtsmaßnahmen führt jedoch die Herstellung dünner Schichten durch Vakuumverdampfung mit diesen Materialien trotzdem zu Schichten mit hoher Absorption im sichtbaren Bereich. Dies trifft insbesondere für Titandioxid zu, das für hochbrechende Schichten als das Ausgangsmaterial der wahl anzusehen ist. Zurückzuführen ist dieser Effekt auf den Verlust von Sauerstoff bei der Hochvakuumverdampfung und der Abscheidung von in Bezug auf den Sauerstoffanteil unterstöchiometrischen Titanoxidschichten.

Diesem Problem läßt sich dadurch beikommen, daß man bei der Verdampfung ein Vakuum mit einem gewissen Sauerstoff-Restdruck (ca. 10⁻⁴ - 10⁻⁵ mbar), also mit einem oxidierenden Charakter, einstellt und/oder die erhaltenen Schichten einer Nachtemperung in Sauerstoff oder Luft unterzieht. Gemäß der oben genannten DE-PS 12 28 489 ist es bei dieser Technik besonders vorteilhaft, den zu verdampfenden Materialien Elemente bzw. Oxide der Gruppe der Seltenen Erden beizufügen.

Obwohl sich durch geeignete Wahl an Zusatzstoffen bzw. die Auswahl entsprechender Stoffgemische die vorgenannten Probleme lösen lassen, ist der Einsatz von Mischsystemen an sich in der Vakuum-Aufdampftechnik nicht zu bevorzugen. Der Grund ist der, daß Mischsysteme in der Regel inkongruent verdampfen, d.h. sie verändern im Verlaufe des Verdampfungsprozesses ihre Zusammensetzung und entsprechend verändert sich auch die Zusammensetzung der abgeschiedenen Schichten. Dies läßt sich normalerweise nur dann vermeiden, wenn es sich bei den Mischsystemen um diskrete chemische Verbindungen handelt, die sich ohne stoffliche Veränderung verdampfen und wieder kondensieren lassen.

Der Erfindung lag nun die Aufgabe zugrunde, ein Aufdampfmaterial zur Herstellung hochbrechender optischer Schichten nach der Vakuumaufdampftechnik zu finden, das die Nachteile der bekannten Materialien nicht aufweist und mit dem sich insbesondere gleichmäßige, homogen zusammengesetzte und im sichtbaren Bereich absorptionsfreie Schichten herstellen lassen.

Vorüberlegungen ließen ein System auf Basis der Oxide von Titan und Lanthan, insbesondere die Verbindung Lanthantitanat (La₂Ti₂O₇) als diesbezüglich interessant erscheinen.

Chemical Abstracts CA112(24):226980n referiert eine Arbeit über die Verdampfung und Kondensation von Lanthaniden-Titanaten im Vakuum. Chemical Abstracts CA106(14):110159y referiert über optisch-physikalische Eigenschaften von Lanthaniden-Titanaten.

Eigene Untersuchungen zum Vakuum-Verdampfungsverhalten von Lanthan-Titan brachten aber das enttäuschende Ergebnis, daß diese Verbindung, ähnlich wie Titandioxid selbst und auch andere Titandioxid enthaltende Mischsysteme, im besonderen Maße zur spontanen Abgabe von Sauerstoff neigt. Diese Abgabe von Sauerstoff erfolgt meist unter heftigem Spritzen, wodurch die Verfahrensdurchführung problematisch zu handhaben ist und sich brauchbare Beschichtungen nur schwer erhalten lassen. Aufgrund des Sauerstoffverlustes sind die erhaltenen Schichten in Bezug auf den Sauerstoffgehalt nicht mehr stöchiometrisch. Die dadurch bedingten starken Absorptionen im sichtbaren Bereich machen eine Nachoxidation durch Temperung in Sauerstoff oder Luft erforderlich.

Überraschend wurde nun gefunden, daß sich Verbindungen der Formel La₂Ti₂O_{7-X} mit x = 0,3 bis 0,7 hervorragend als Aufdampfmaterial zur Herstellung hochbrechender optischer Schichten durch Vakuumverdampfung eignen. Es hat sich gezeigt, daß diese Materialien sich problemlos und ohne Spritzen im Vakuum verdampfen lassen und unter den in der Vakuumverdampfungstechnik üblichen Arbeitsbedingungen ohne weiteres zu absorptionsfreien Schichten führen.

Gegenstand der Erfindung ist somit ein Aufdampfmaterial zur Herstellung hochbrechender optischer Schichten durch Bedampfen von Substraten im Vakuum, bei dem es sich um eine Verbindung der Formel La₂Ti₂O_{7-X} mit x = 0,3 bis 0,7 handelt.

Gegenstand der Erfindung ist weiterhin ein Verfahren zur Herstellung von hochbrechenden optischen Schichten, bei dem man Substrate im Vakuum mit einem derartigen Aufdampfmaterial bedampft.

Die erfindungsgemäßen Aufdampfmaterialien weisen gegenüber der stöchiometrisch exakt zusammengesetzten Basisverbindung Lanthantitanat (La₂Ti₂O₇) einen im Rahmen der vorstehend angegebenen Formeldefinition liegenden Sauerstoff-Unterschuß auf. Durch die gezielte Einstellung des Sauerstoff-Unterschusses in den erfindungsgemäßen Materialien tritt einerseits während der Vakuumverdampfung keine weitere Abgabe von Sauerstoff auf, die zu dem unerwünschten Spritzen des erschmolzenen Materials führt. Andererseits liegt der gewählte Bereich des Sauerstoffunterschusses so, daß sich unter den üblichen Arbeitsbedingungen bei der Vakuumverdampfungstechnik noch ohne weiteres absorptionsfreie Schichten bilden. Hierbei zeigte es sich außerdem, daß die optischen Eigenschaften der erhaltenen Schichten kaum durch Schwankungen des Sauerstoffrestdrucks während der Vakuumverdampfung beeinflußt werden. Ein höherer Sauerstoff-Unterschuß als angegeben, führt jedoch zu unerwünscht absorbierenden Schichten.

Diese Befunde sind im besonderen Maße überraschend und nicht vorhersehbar.

Als besonders bevorzugtes Aufdampfmaterial ist eine Verbindung anzusehen, die sich durch die Formel La₂Ti₂O_{6,5} charakterisieren läßt.

Die erfindungsgemäßen Aufdampfmaterialien lassen sich in der Weise erhalten, daß man die Oxide von Lanthan und Titan sowie ggf. metallisches Titan im entsprechenden stöchiometrischen Verhältnis mischt und im Hochvakuum unterhalb der Schmelztemperatur sintert. Ein derartiges Herstellverfahren für die erfindungsgemäßen Aufdampfmaterialien ist ebenfalls Gegenstand der Erfindung. Die Hauptkomponenten des Ausgangsmaterials sind Lanthanoxid (La₂O₃) und Titandioxid (TiO₂); zur Einstellung des gewünschten Sauerstoffunterschusses können die Suboxide von Titan, nämlich Ti₂O₃ und TiO, oder auch metallisches Titan dienen. Das gesinterte Produkt zeigt ein schwarzes Aussehen, schmilzt ab einer Temperatur von ca. 1800 °C vollständig ein und läßt sich in einem Vakuum von ca. 10⁻⁴ mbar bei Temperaturen zwischen 2200 und 2300 °C verdampfen.

Das erfindungsgemäße Aufdampfmaterial kann in den in der einschlägigen Technik üblichen Vakuum-Aufdampfapparaturen bzw. -Anlagen in bekannter Weise und unter den hierfür gängigen Verarbeitungsbedingungen eingesetzt werden. Die Vakuumverdampfung kann nicht nur durch thermische Verdampfung sondern auch durch Elektronenstrahl-Verdampfung vorgenommen werden.

Mit dem erfindungsgemäßen Material können auf beliebigen geeigneten Substraten homogene dünne Schichten gleichmäßiger Schichtdicke erzeugt werden, die haftfest und in besonderem Maße gegen mechanische und chemische Einflüsse resistent sind. Die Schichten sind hochberechend; ihr Brechungsindex liegt, je nach Zusammensetzung und in Abhängigkeit von der Wellenlänge bei der gemessen wird, bei Werten um 2,0. Die Schichten haben eine hohe Transmission in einem Wellenlängenbereich vom nahen UV (ab etwa 360 nm) über den sichtbaren Bereich bis in das nahe IR (ca. 7000 nm) und sind insbesondere im sichtbaren Wellenlängenbereich frei von Absorptionen.

Das erfindungsgemäße Aufdampfmaterial kann besonders vorteilhaft bei der Beschichtung von Substraten eingesetzt werden, die nicht oder nur wenig, z.B. bis ca. 80 °C, erwärmt werden können. Zu derartigen temperaturempfindlichen Substraten zählen Kunststoffe und verkittete Glasoptiken. Hierfür werden Aufdampfmaterialien benötigt, die auch ohne Substraterhitzung haltbare, haftfeste und absorptionssfreie homogene Schichten ergeben.

Bei bekannten Substanzen, wie Tantaloxid, Titanoxid, Zirkonoxid sowie Mischungen, z.B. aus Praseodymoxid und Titanoxid, ergeben sich bei der Beschichtung von nicht beheizten Substraten Probleme durch Absorption oder Inhomogenität der Schichten.

Mit dem erfindungsgemäßen Material erhält man überraschenderweise auch bei nicht beheizten Substraten absorptionsfreie homogene Schichten.

### Beispiel 1: Herstellung

Es wird aus
68,2 Gew.% Lanthan(III)oxid
29,3 Gew.% Titan(IV)oxid
2,5 % Titan (metallisch)
ein Pulvergemisch hergestellt und dieses granuliert. Die Zusammensetzung ist so gewählt, daß sich eine Verbindung der Formel La₂Ti₂O_{6,5} bildet.

Das Granulat wird im Hochvakuum (10⁻⁴ mbar) bei einer Temperatur von 1800 °C 5 Stunden gesintert. Das erhaltene schwarze Produkt hat eine Dichte von 5,9 g/cm³ und einen Schmelzpunkt von 1800 °C.

### Beispiel 2: Anwendung

Das Granulat von Beispiel 1 wird in einen Verdampfungstiegel aus Molybdän gefüllt und in eine handelsübliche Vakuumaufdampfapparatur mit Elektronenstrahl-Verdampfung verbracht.

Das zu bedampfende Substrat besteht aus Quarz.

Die Beschichtung erfolgt bei einer Temperatur von 2200 bis 2300 °C und einem O₂-Restdruck von 2 × 10⁻⁴ mbar bei einer Substrattemperatur von 250 °C und mit einer Abscheidungsrate von 0,4 nm/sec bis eine Schichtdicke von 250 nm erreicht ist.

Die Schicht hat einen Brechungsindex bei 500 nm von n = 2,12. Die Schicht zeigt keine Absorption im sichtbaren Bereich und bis zu einer Wellenlänge von 375 nm.

### Beispiel 3 Beschichtung von Kunststoff-Substraten

Das Granulat aus Beispiel 1 wird in einen Verdampfungstiegel aus Molybdän gefüllt und in eine Vakuumverdampfungsapparatur mit Elektronenstrahl-Verdampfung gebracht.

Das zu bedampfende Substrat besteht aus Kunststoff (Polycarbonat).

Die Beschichtung erfolgt bei einer Temperatur von 2200 bis 2300 °C und einem O₂-Restdruck von 2 × 10⁻⁴ mbar bei einer Abscheidungsrate von 0,4 nm/sec auf unbeheizte Substrate bis eine Schichtdicke von etwa 250 nm erreicht ist.

Die Schicht hat einen Brechungsindex von etwa 1,98 (nicht erwärmt) bzw. von 2,02 (Erwärmung auf etwa 50 °C) bei 500 nm. Die Schicht ist homogen und zeigt keine Absorption bis zu Wellenlängen von 390 nm.

## Patentansprüche

1. Aufdampfmaterial zur Herstellung hochbrechender optischer Schichten durch Bedampfen von Substraten im Vakuum, dadurch gekennzeichnet, daß es sich um eine Verbindung der Formel La₂Ti₂O_{7-X} mit x = 0,3 bis 0,7 handelt.

2. Aufdampfmaterial nach Anspruch 1, dadurch gekennzeichnet, daß es sich um eine Verbindung der Formel La₂Ti₂O_{6,5} handelt.

3. Verfahren zur Herstellung von Aufdampfmaterialien nach den Ansprüchen 1 und 2, dadurch gekennzeichnet, daß man Oxide von Lanthan und Titan sowie ggf. metallisches Titan im entsprechenden stöchiometrischen Verhältnis mischt und im Hochvakuum unterhalb der Schmelztemperatur sintert.

4. Verwendung der Aufdampfmaterialien nach den Ansprüchen 1 und 2 zur Herstellung von hochbrechenden optischen Schichten.

5. Verfahren zur Herstellung von hochbrechenden optischen Schichten durch Bedampfen von Substraten im Vakuum, dadurch gekennzeichnet, daß man mit Aufdampfmaterialien nach den Ansprüchen 1 und 2 bedampft.

## Claims

1. Vapour-deposition material for the production of high-refraction optical coatings by vapour-deposition of substrates in vacuo, characterised in that the material is a compound of the formula La₂Ti₂O₇₋ₓ where x = 0.3 to 0.7.

2. Vapour-deposition material according to Claim 1, characterised in that the material is a compound of the formula La₂Ti₂O_{6.5}.

3. Process for the preparation of vapour-deposition materials according to Claims 1 and 2, characterised in that oxides of lanthanum and titanium and, if desired, metallic titanium are mixed in the appropriate stoichiometric ratio, and the mixture is sintered in high vacuum and below the melting point.

4. Use of the vapour-deposition materials according to Claims 1 and 2 for the production of high-refraction optical coatings.

5. Process for the production of high-refraction optical coatings by vapour-deposition of substrates in vacuo, characterised in that the vapour deposition materials according to Claims 1 and 2 are used.

## Revendications

1. Matière à vaporiser pour la fabrication de couches optiques à haut indice de réfraction par vaporisation sur substrats dans le vide, caractérisée en ce qu'elle consiste en un composé de formule :
La₂Ti₂O₇₋ₓ
dans laquelle x a une valeur de 0,3 à 0,7.

2. Matière à vaporiser selon la revendication 1, caractérisée en ce qu'elle consiste en un composé de formule :
La₂Ti₂O_{6,5}

3. Procédé de préparation de matières à vaporiser selon les revendications 1 et 2, caractérisé en ce que l'on mélange des oxydes du lanthane et du titane et, le cas échéant, du titane métallique en proportions stoechiométriques appropriées et on les fritte sous haut vide au-dessous de la température de fusion.

4. Utilisation des matières à vaporiser selon les revendications 1 et 2 pour la fabrication de couches optiques à haut indice de réfraction.

5. Procédé pour la fabrication de couches optiques à haut indice de réfraction par vaporisation sur substrats dans le vide, caractérisé en ce que l'on vaporise avec des matières à vaporiser selon les revendications 1 et 2.
